# EUROPEAN PATENT APPLICATION

(11) **EP 4 570 944 A1**
(43) Date of publication of application: **18.06.2025**
(21) Application number: 24020281.2
(22) Date of filing: 30.08.2024
(51) Int. Cl.: C23C 16/02, C23C 16/06, C23C 16/40, C23C 16/455

(54) **THE METHOD OF OBTAINING PLATES WITH ALUMINIUM (III) OXIDE NANOLAYERS AND THE APPLICATION OF PLATED WITH ALUMINIUM (III) OXIDE NANOLAYERS**

(30) Priority: 30.08.2023 PL 44595323
(71) Applicant: Uniwersytet Mikolaja Kopernika w Toruniu, 87-100 Torun (PL)
(72) Inventor: Pomastowski, Pawel, 87-134 Zlawies Wielka (PL); Radtke, Aleksandra, 87-100 Torun (PL); Piszczek, Piotr, 87-100 Torun (PL); Sagandykova, Gulyaim, 87-100 Torun (PL)

(57) **Abstract**

The subject of the invention is the method of obtaining plates coated with aluminum(III) oxide nanolayers as well as aluminum(III) oxide nanolayers covered with silver nanograins for the spectrometric analysis with the use of nanolayer-asssted laser deposition/ionization (NALDI) and the application of aluminum(III) oxide nanolayers. The invention concerns the atomic layer deposition techniques as well as chemical vapor deposition for the synthesis of nanomaterials applied in mass spectrometry.

## Description

The subject of the invention is the method of obtaining plates coated with aluminum(III) oxide nanolayers as well as aluminum(III) oxide nanolayers covered with silver nanograins for the spectrometric analysis with the use of nanostructure-assised laser deposition/ionization (NALDI). The invention concerns the atomic layer deposition techniques as well as chemical vapor deposition for the synthesis of nanomaterials applied in mass spectrometry. The subject of the invention is also the application of plates with aluminum(III) oxide nanolayers.

In the context of the mass spectrometry techniques, the nanolayer-assisted laser deposition/ ionization (NALDI) method constitutes a modern approach that enables the analysis of compounds of low molecular mass (<3000 Da). In comparison to the MALDI technique, NALDI eliminates the problem of background interferences from the organic matrix, which significantly improves the quality of the obtained mass spectra. The developed invention is focused on the method of preparing steel plates coated with aluminum(III) oxide nanolayers as well as aluminum(III) oxide nanolayers coated with silver nanograins that are intended to assist in the desorption/ionization processes in mass spectrometry, which makes them especially efficient in NALDI applications. NALDI, as an analytical technique, is based on the application of surfaces coated with nanostructures for desorption and ionization of a sample without the need to use a matrix. The technology allows obtaining more precise mass spectra, particularly for compounds of low molecular mass. Owing to this, NALDI has been winning popularity in medical diagnostics as well as analysis of biologically active compounds.

The aim of the invention is the development of a method of preparing plates coated with aluminum(III) oxide nanolayers as well as aluminum(III) oxide nanolayers and silver nanograins with the use of the atomic layer deposition (ALD) and chemical vapor deposition techniques. The invention is based on the preparation of steel plates coated with aluminum(III) oxide nanolayers as well as coated with aluminum(III) oxide nanolayers and silver nanograins, which are intended to assist desorption and ionization in mass spectrometry.

The method of obtaining plates with aluminum(III) oxide nanolayers is characterized in that stainless steel plates are cleaned, degreased, and dried, and next on their surfaces patterns are engraved with the use of a pneumatic microimpact marking machine. The process is performed with the minimum punching point of the 1x1 mm size, and the knock out speed of 3 to 6 beats per second. The punching depth is from 0.01 to 2 mm, in dependence on a metal hardness. The marker hardness is HRC95, which enables marking materials of hardness not exceeding HRC65. The marking accuracy is 0.05 mm, and the process occurs under air pressure in the range of 0.3-0.8 MPa, until spots of 0.10 to 10 mm in diameter and indentations of 0.1 mm to 0.5 mm in width are formed on the surface.

The subject of the invention is the method of obtaining plates with aluminum(III) oxide nanolayers characterized in that stainless steel plates are cleaned, degreased, and dried, and next compressed air is applied to the surface of the plates until spots of 0.10 to 10 mm in diameter and indentations of 0.1 mm to 0.5 mm in width are formed on the surface, next the plates are cleaned in an ultrasonic cleaner in a mixture of acetonitrile and ethanol in the volume ratio from 0.5:1 v/v to 1:2 v/v preferably 1: 1 v/v of purity not lower than 99.95 % v/v, rinsed in distilled water, rinsed in acetone, dried in a stream of argon, and activated in a solution of trifluoroacetic acid at the concentration from 0.1% to 10%, and next, in the ALD deposition process, at least one layer of Al₂O₃ is deposited on the plate, preferably from one to twenty layers, of 1 to 10 nm in thickness, under the process conditions from 10 to 500 cycles, the chamber temperature from 120 to 400°C, the introduction of a trimethylaluminum precursor from 100 to 150 ms, cleaning with nitrogen after trimethylaluminum from 500 to 1000 ms, introduction of a water precursor from 90 to 260 ms and cleaning with nitrogen after the introduction of water from 500 to 1500 ms. Preferably the plates with Al₂O₃ layers are dried in a stream of argon preferably in the time from 10 to 60 min and silver nanograins are deposited in the CVD process with the use of silver(I) pentafluoropropionate trihydrate of the molecular formula [Ag₅(O₂CC₂F₅)₅(H₂O)₃] in the amount from 0.1µg to 1000 µg, with the silver nanogains size from 1 nm to 100 nm, at the evaporation temperature from 200°C to 280°C, decomposition and deposition temperature from 200°C to 350°C, under the pressure in the reactor from 2.0 to 4.0 mbar, the time of heating the sample from 20 to 60 min and time of deposition from 30 to 120 min, next after the deposition process the plates are cooled. Preferably the sizes of the plate are from 0.5 to 30cm preferably 2.5 × 7.5 cm. Preferably the steel is austenitic preferably AISI 304, ferritic preferably AISI 430, martensitic preferably AISI 410, duplex steel preferably AISI 2205. Preferably cleaning is conducted by rinsing the plate surface with a solution of ethanol preferably in the time from 20 to 120 minutes, drying preferably in a stream of argon or nitrogen most preferably in the time from 1 to 20 minutes, next rinsing with a solution of trichloroacetic acid of the concentration in the range from 0.01% to 10% most preferably in the time from 10 to 120 minutes. Preferably the plates are dried for 10 to 60 minutes. Preferably rinsing in water and acetone is performed for one to ten times, preferably each time for 2 to 20 minutes. Preferably the plates are dried in a stream of argon. Preferably the plates are cooled to the temperature of 10 to 35°C preferably in an oven. Preferably after cooling the plates are stored in a sealed and dry container, preferably with no access to light.

The subject of the invention is also the application of plates coated with aluminum(III) oxide prepared according to the invention for the analysis of low molecular mass compounds with the use of the nanolayer-assisted laser deposition/ionization (NALDI) technique.

The invention constitutes a new approach to the preparation of plates applied in mass spectrometry by increasing the precision and reliability of analysis. The use of the atomic layer deposition technique to prepare aluminum(III) oxide nanolayers as well as aluminum(III) oxide nanolayers coated with silver nanograins on a steel plate offers a broad range of benefits in comparison to traditional methods applied in this field. Plates coated with aluminum(III) oxide nanolayers as well as aluminum(III) oxide nanolayers coated with silver nanograins are applied in the analysis of low molecular mass compounds with the use of nanolayer-assisted laser deposition/ionization (NALDI) technique. Aluminum(III) oxide nanolayers as well as aluminum(III) oxide nanolayers coated with silver nanograins on plates enable effective desorption and ionization of these compounds, which leads to obtaining high-quality mass spectra characterized by increased sensitivity and precision of detection. The method allows the detection and analysis of compounds of molecular mass lower than 3000 Da, particularly in the case of samples of low concentration, which makes it especially useful in advanced chemical, biological, or pharmaceutical analyses.

The invention is also disclosed in the figures in the drawing.

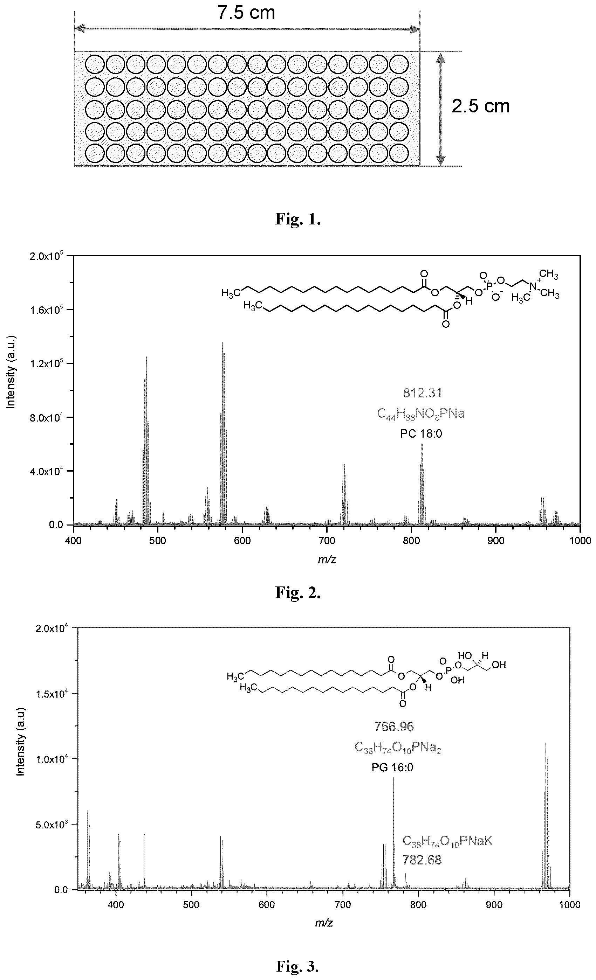

Fig 1. Scheme of making spots on an acid-resistant stainless steel plate
Fig 2. NALDI-MS spectrum (of a plate with an Al₂O₃ layer enriched with silver nanoparticles) of 1,2-distearoyl-sn-glycero-3-phosphocholine (CAS 816-94-4) collected in the ionic mode with the use of NALDI targets prepared by atomic layer deposition and under following instrumental conditions: global attenuator 25%, laser power 80%, detector gain: 30x; concentration: 1 mg/ml
Fig 3. NALDI-MS spectrum (of a plate with an Al₂O₃ layer enriched with silver nanoparticles) of 1,2-dipalmitoyl-sn-glycero-3-phospho-(1'-rac-glycerol) (CAS 200880-41-7) collected in the ionic mode with the use of NALDI targets prepared by atomic layer deposition and under the following instrumental conditions: global attenuator 30%, laser power 80%, detector gain: 2,51x; concentration: 1 mg/ml

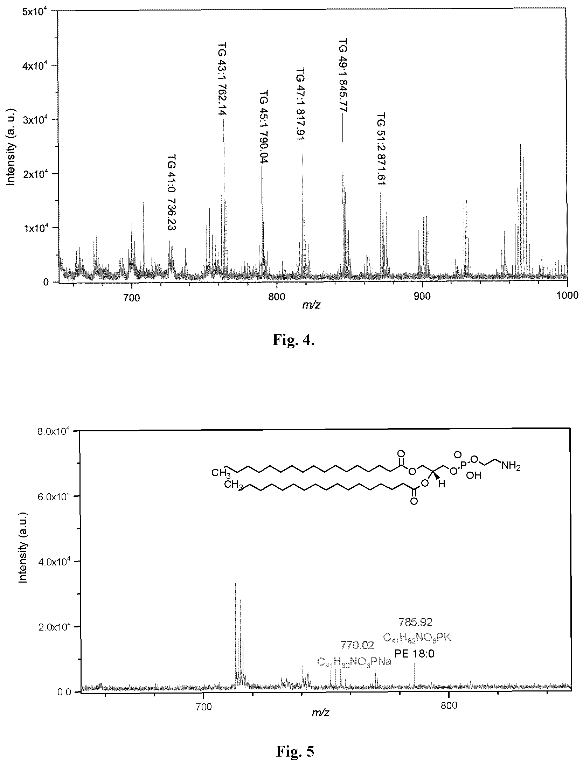

Fig 4. NALDI-MS spectrum (of a plate with an Al₂O₃ layer enriched with silver nanoparticles) of a mixture of triacylglycerols (Ultimate SPLASH^{™}, Avanti Polar Lipids, Alabaster, AL, USA) at the following concentrations: TG 41:0 (25 µg/ml); TG 43:1 (50 µg/ml); TG 45:1 (75 µg/ml); TG 47:1 (100 µg/ml); TG 49:1 (125 µg/ml); TG 49:1 (100 µg/ml); TG 51:2 (75 µg/ml); parameters: global attenuator 35%, laser power 80%, detector gain: 30x
Fig 5. NALDI-MS spectrum (of a plate with an Al₂O₃ layer enriched with silver nanoparticles) of 1,2-dioctadecanoyl-*sn*-glycero-3-phosphoethanolamine (CAS 1069-79-0) collected in the ionic mode with the use of NALDI targets prepared by atomic layer deposition and under the following instrumental conditions: global attenuator 30%, laser power 80%, detector gain: 30x; concentration: 1 mg/ml

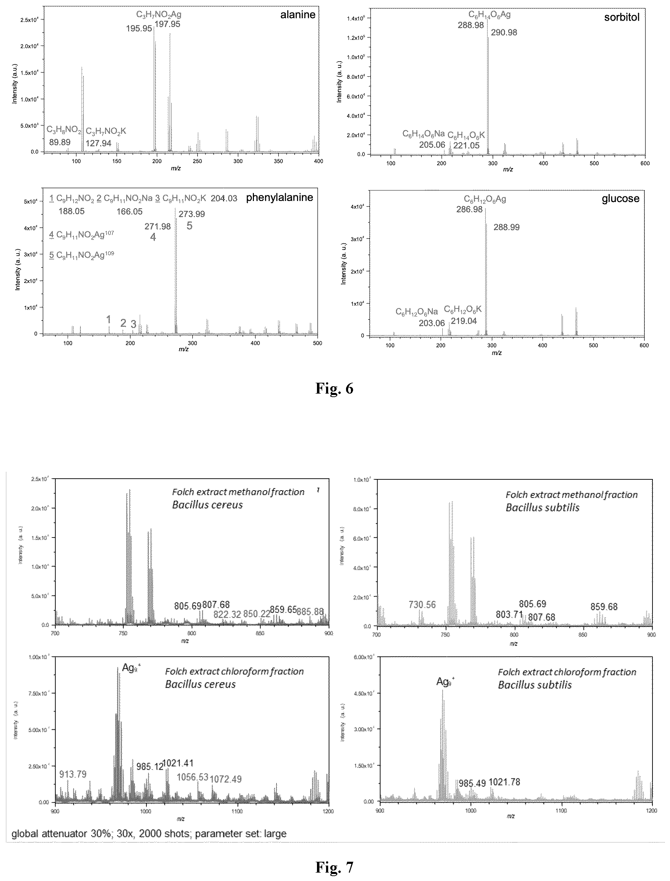

Fig 6. NALDI-MS spectrum (of a plate with an Al₂O₃ layer enriched with silver nanoparticles) of low molecular compounds collected in the ionic mode with the use of NALDI targets prepared by atomic layer deposition and under the following instrumental conditions: global attenuator 30%, laser power 80%, detector gain: 2,51x, concentration: 1 mg/ml
Fig 7. NALDI-MS spectra (of a plate with an Al₂O₃ layer enriched with silver nanoparticles) of low molecular mass (bacterial extracts) collected in the ionic mode with the use of NALDI targets prepared by atomic layer deposition and under the following instrumental conditions: global attenuator 30%, laser power 80%, detector gain: 30x, extraction method: Folch method (methanol and chloroform fraction). Analyzed Folch's bacteria extracts: *Bacillus subtillis*, *Bacillus cereus,*

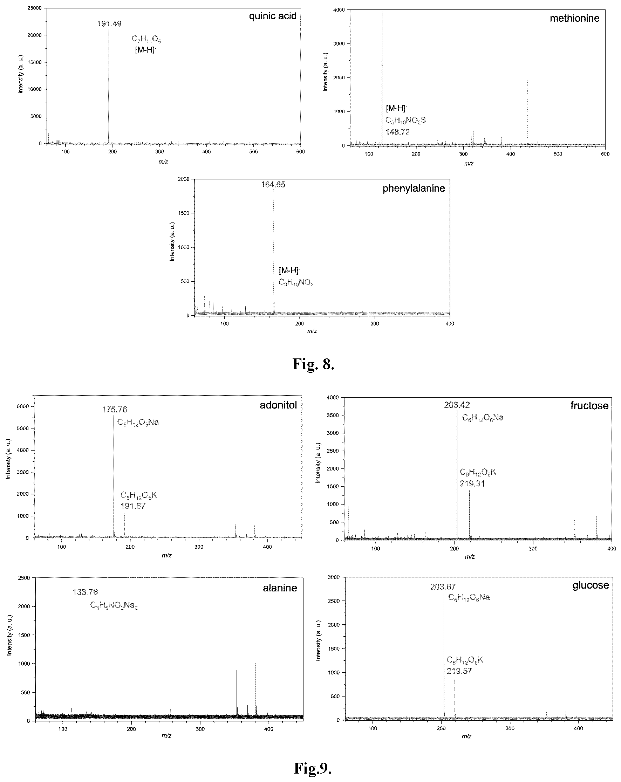

Fig 8. NALDI-MS spectra (of a plate with an Al₂O₃ layer enriched with silver nanoparticles) of low molecular mass compounds collected in the ionic mode with the use of NALDI targets prepared by atomic layer deposition and under the following instrumental conditions: global attenuator 30%, laser power 80%, detector gain: 2,51x, concentration: 1 mg/ml; calibration: clusters CsI3
Fig 9. NALDI-MS spectra (of a plate with an Al₂O₃ layer enriched with silver nanoparticles) of low molecular mass compounds collected in the ionic mode with the use of NALDI targets prepared by atomic layer deposition and under the following instrumental conditions: global attenuator 30%, laser power 80%, detector gain: 2,51x, concentration: 1 mg/ml; calibration: clusters CsI3

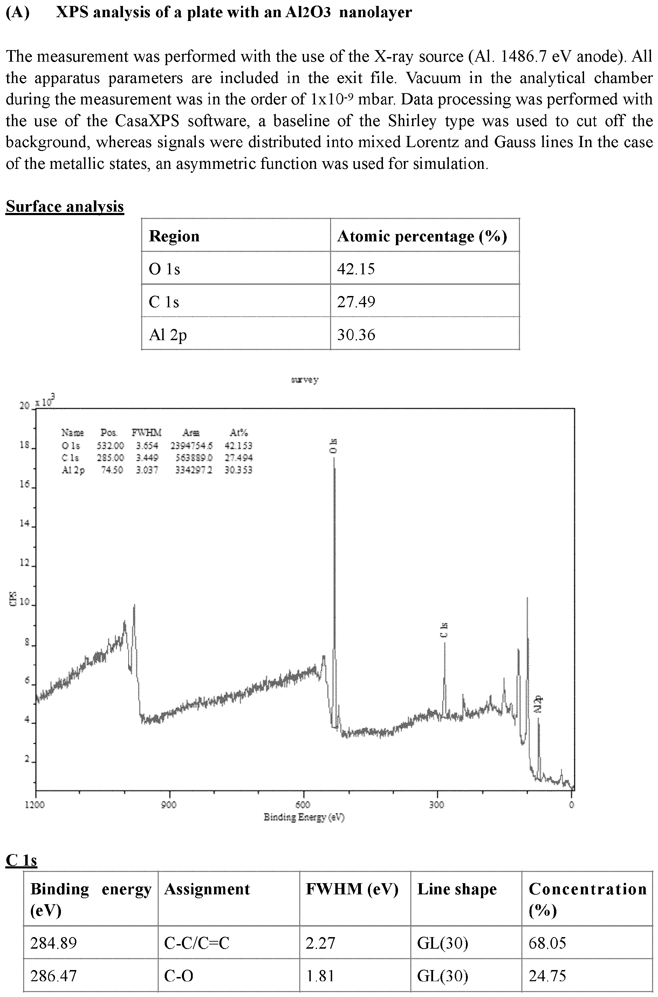

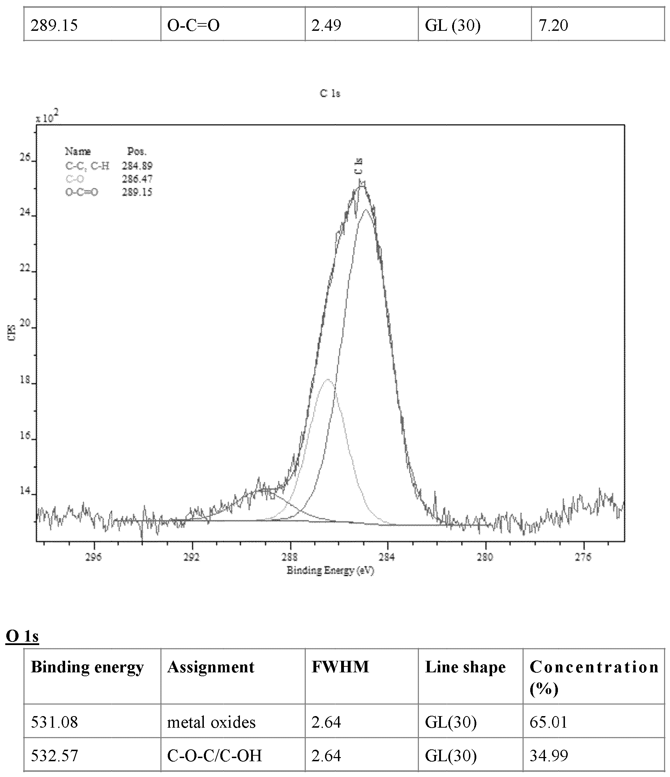

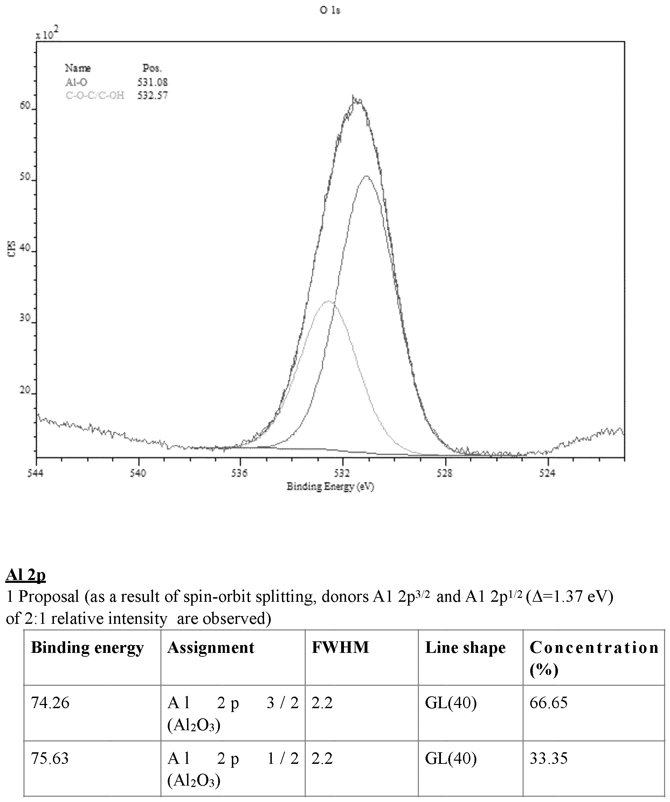

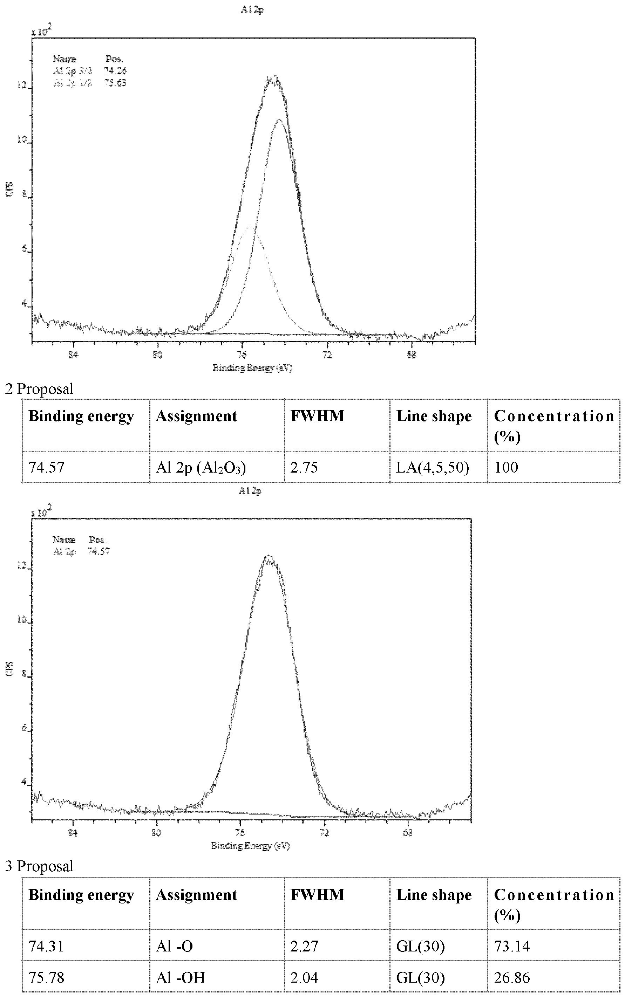

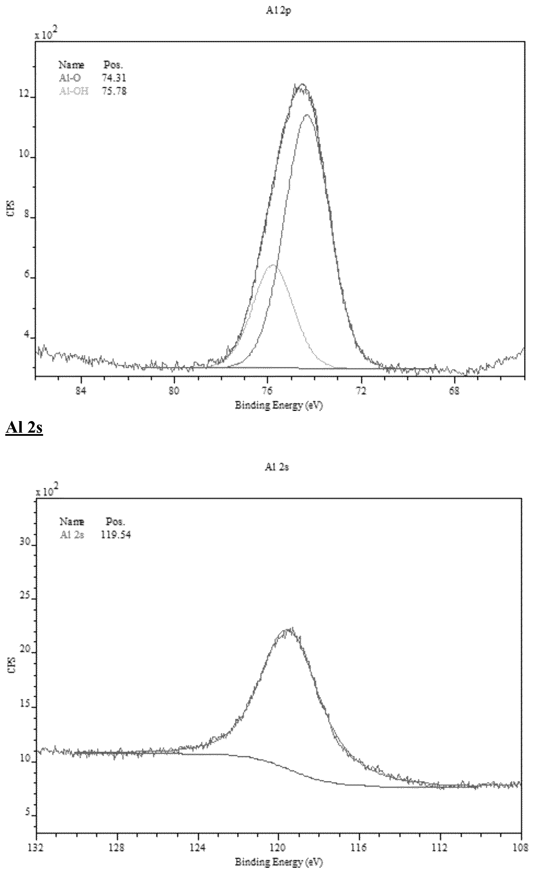

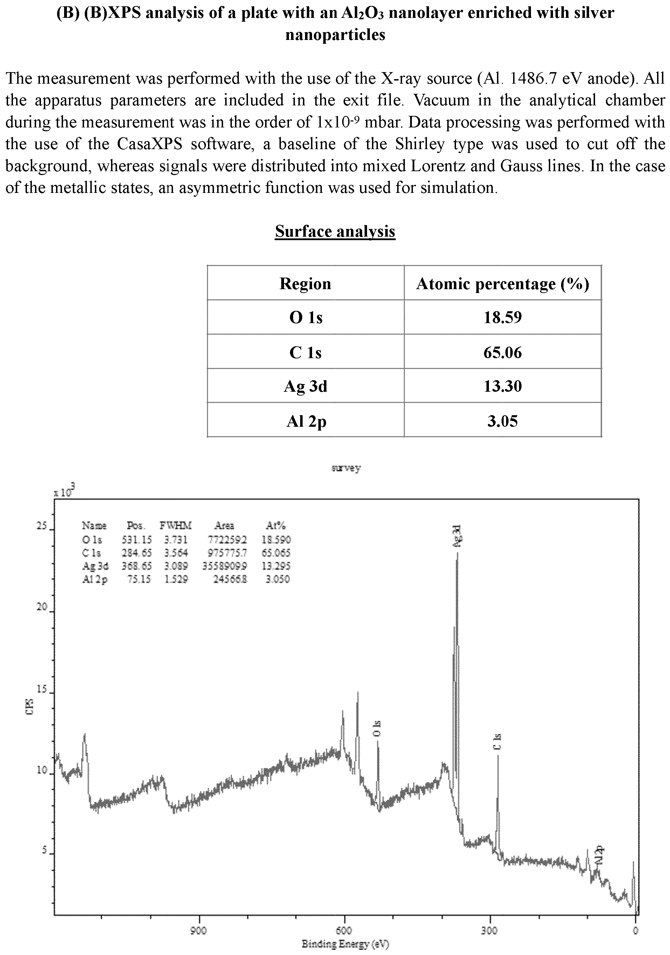

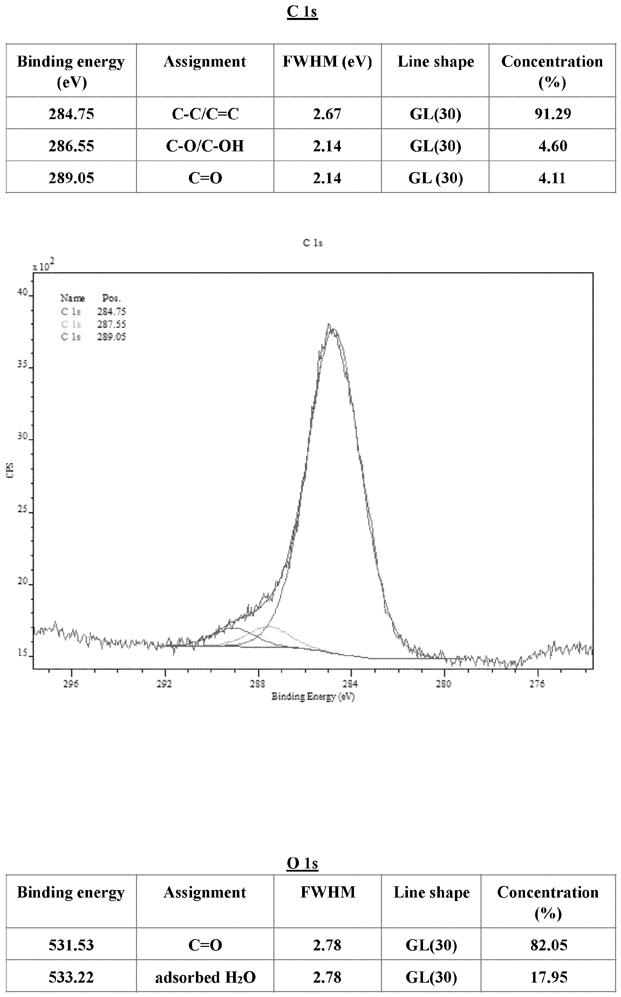

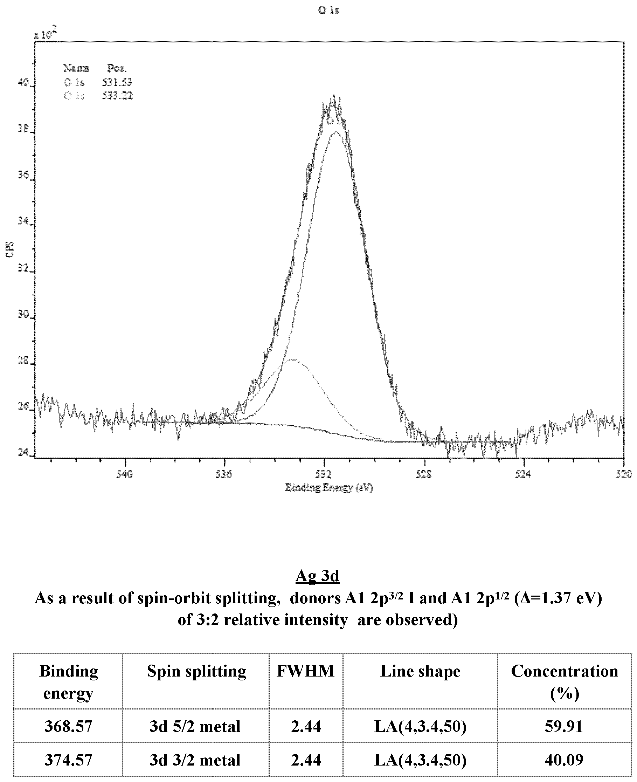

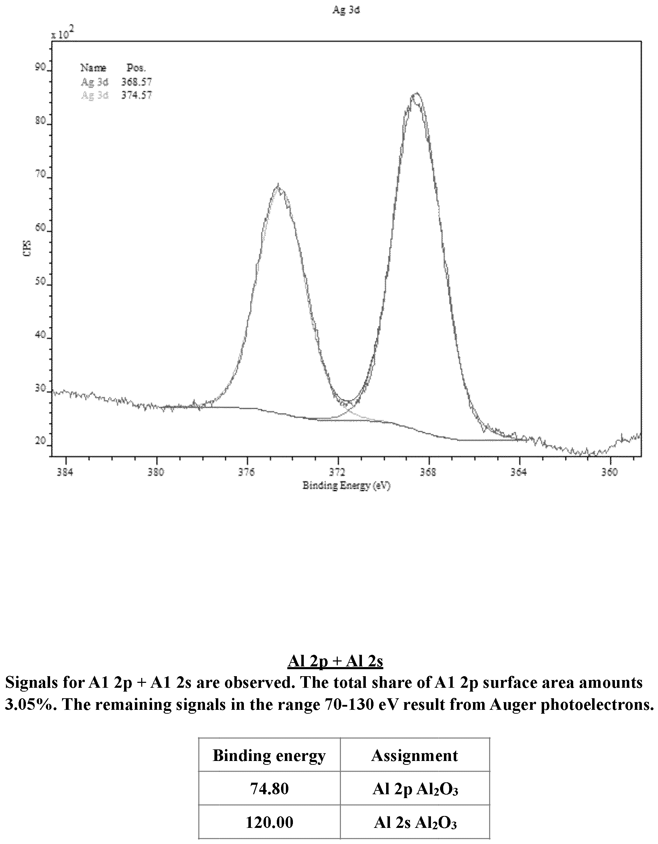

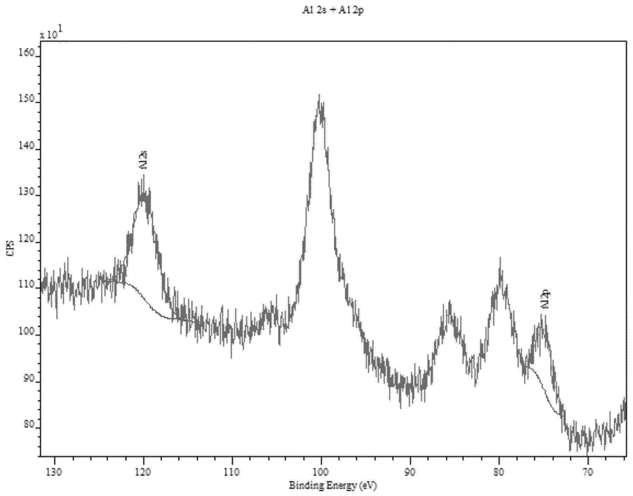

Fig 10. XPS analysis of a plate with an Al₂O₃ nanolayer (A) and of a plate with an Al₂O₃ nanolayer enriched with silver nanoparticles (B).

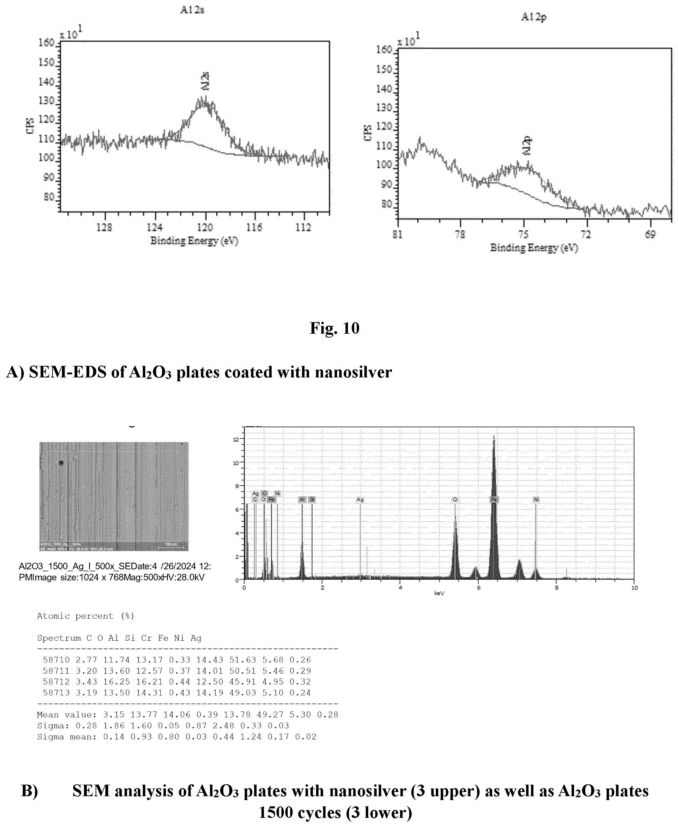

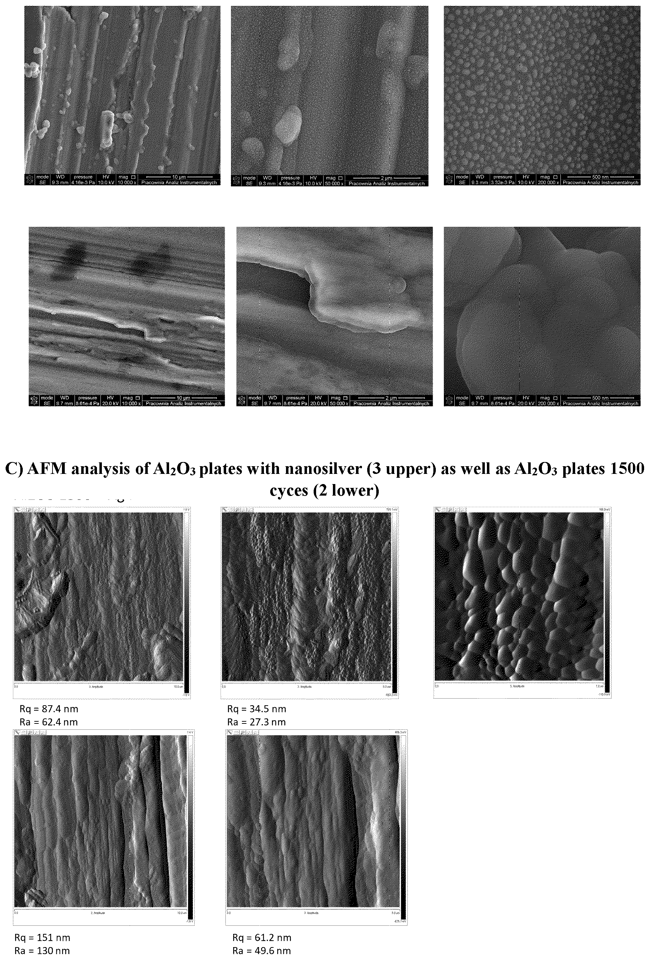

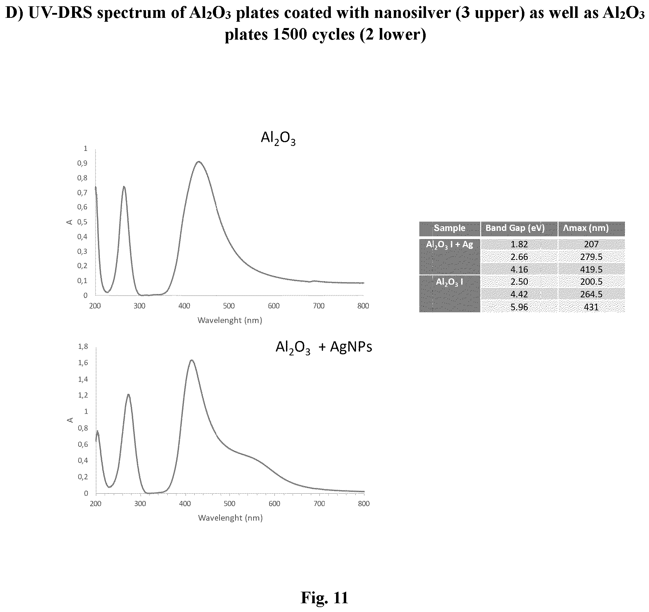

Fig. 11. A) SEM-EDS of Al₂O₃ plates with nanosilver, B) SEM analysis of Al₂O₃ plates with nanosilver (3 upper) and Al₂O₃ plates 1500 cycles (3 lower), C) AFM analysis of Al₂O₃ plates with nanosilver (3 upper) and Al₂O₃ plates 1500 cycles (2 lower), D) UV-DRS spectra Al₂O₃ plates with nanosilver (3 upper) and Al₂O₃ plates 1500 cycles (2 lower)

The invention is applied in mass spectrometry to analyze low molecular mass compounds (m < 3000 Da), offering an improvement in background interferences reduction and an increase in the efficiency of an analysis.

The uniform nanolayers obtained with this method ensure perfect analytical signal mapping. They also enable controlling the morphology of the nanostructures, which allows the adjustment of optical properties of a substrate. There is also no need to use stabilizers, which minimizes background interferences.

### Example I

The invention relates to the method of producing stainless steel plates coated with aluminum(III) oxide with the use of the atomic layer deposition (ALD) technique applicable in mass spectrometry where desorption and ionization are assisted by these nanostructures (NALDI).

The method begins with cutting stainless steel to an appropriate size, and next, it is cleaned, degreased, and prepared for the ALD process. With the use of trimethylaluminum and water as precursors, an Al₂O₃ layer of exactly defined thickness is formed on the plate surface.

### I. Steel plates - specification:

The substrates for the deposition of nanostructures are stainless steel plates available in different variants: austenitic (e.g. AISI 304), ferritic (e.g. AISI 430), martensitic (e.g. AISI 410) as well as duplex steel (e.g. AISI 2205). According to the technical description of the materials used for producing plates, different types of steel of varied chemical characteristics were used. Austenitic steel, AISI 304 for instance, is characterized by chromium (Cr) content in the amount from 18 to 20%, nickel (Ni) - from 8 to 10%, manganese (Mn) - up to 2%, carbon (C) - up to 0.08%, silicon (Si) - up to 1%, phosphorus (P) - up to 0.045% as well as sulfur (S) - up to 0.03%. In the same class, the content of molybdenum (Mo) is usually low or it is not present.

Ferritic steel, AISI 430 for instance, is characterized by low chromium (Cr) content in the amount from 16 to 18%, carbon (C) - up to 0.12%, manganese (Mn) - up to 1%, phosphorus (P) - up to 0.04% as well as sulfur (S) - up to 0.03%.

Martensitic steel, AISI 410 for instance, is characterized by chromium (Cr) content in the range from 11.5 to 13.5%, carbon (C) - from 0.08 to 0.15%, manganese (Mn) - up to 1%, phosphorus (P) - up to 0.04% as well as sulfur (S) - up to 0.03%.

Duplex steel, containing both austenite and ferrite, AISI 2205 for instance, is characterized by chromium (Cr) content in the range from 21 to 23%, nickel (Ni) - from 4.5 to 6.5%, manganese (Mn) - up to 2%, carbon (C) - up to 0.03%, silicon (Si) - up to 1%, phosphorus (P) - up to 0.03%, sulfur (S) - up to 0.02% as well as molybdenum (Mo) - from 2.5 to 3.5%.

The ability to conduct electrical charge as well as compatibility with the atomic layer deposition (ALD) technique are the key features necessary for NALDI applications.

In the example of embodiment, AISI 304 was applied.

### II. Plate preparation process:

1, Cutting steel: steel sheets of 0.8cm thickness and 1000x250mm of size are cut in the example of embodiment to the size (2.5 × 7.5 cm) with the use of water cutting technique.
2. Cleaning: In order to ensure the optimum nanolayers adhesion, plates are carefully cleaned. Performing the cleaning and degreasing process on the plate surface requires using proper solvents. To achieve it, rinsing the plate surface with an ethanol solution for the period of 20 to 120 minutes, in the example of embodiment for 60 minutes, is required. Next, after drying in a stream of argon or nitrogen for the period of 1 to 20 minutes, in the example of embodiment for 10 minutes, rinsing with a solution of trichoroacetic acid of the concentration within the range from 0.01% do 10% is performed, in the example of embodiment 5%, of plates coated with Al₂O, for the period from 10 to 120 minutes, in the example of embodiment for10 minutes. In the final stage, the plate is dried for the period of 10 to 60 minutes, in the example of embodiment for 30 minutes.

Making spots: patterns (spots) are engraved, in the example of embodiment - circles, with the use of a pneumatic microimpact marking machine. The process is performed with the minimum punching point of the 1x1 mm size, and the knock out speed of 3 to 6 beats per second. The punching depth is from 0.01 to 2 mm, in dependence on a metal hardness. The marker hardness is HRC95, which enables marking materials of hardness not exceeding HRC65. The marking accuracy is 0.05 mm, and the process occurs under air pressure in the range of 0.3-0.8 MPa, until spots of 0.10 to 10 mm in diameter and indentations of 0.1 mm to 0.5 mm in width are formed on the surface.
3. The spots diameter is within the range from 0.10 to 10 mm in the example of embodiment - 4,0 mm, and their boundaries are marked by indentations of the breadth from 0.1 mm to 0.5 mm, in the example of embodiment - 0.3 mm. The method also constitutes the manner in which samples can be concentrated in space.

### III. Atomic layer deposition (ALD) process:

1. Re-cleaning and surface activation: Before conducting the nanolayer deposition process, plates undergo cleaning i.e. they are placed in an ultrasonic cleaner with a specialized washing agent which is a mixture of acetonitrile and ethanol in the volume ratio of 1: 1 v/v of purity not lower than that for spectrometric (MS) analyses, i.e. not lower than 99.95%, Next, in order to activate the surface, the substrates are exposed to the activity of a trifluoroacetic acid solution. For this purpose, the plates are rinsed twice in distilled water, and next in acetone for 2 to 20 minutes, in the example of embodiment for 10 minutes, next are dried in a stream of argon for 1 to 10 minutes, in the example of embodiment - for 5 minutes. The next step is the surface activation in a trifluoroacetic acid solution (TFA) at the concentration from 0.1% to 10%, in the example of embodiment - 1%.
2. Advanced preparation of aluminum trioxide nanolayers with the ALD method

The invention relates to the methodology of preparing aluminum trioxide (Al₂O₃) nanolayers on steel substrates with the use of the atomic layer deposition (ALD) technique. The process enables the deposition of layers of a precisely controlled thickness, which finds its applications in numerous fields of science and technology.

Substrate: Steel plates of 0.2 to 1.6 cm in thickness, in the example of embodiment - 0.8 cm are used as the substrate.

Layer deposition: With the use of the ALD technique (ALD reactor manufactured by Beneq, Espoo, Finland, model TFS 200-302, year of production: 2021) Al₂O₃ layers of 1 to 10 nm in thickness are deposited, in the example of embodiment - 5 nm. In order to do this from 10 to 2500 ALD cycles are performed, in the example of embodiment - 1500 cycles.

Precursors: Two main precursors are used in the process: trimethylaluminum (Al(CH₃)₃) and water (H₂O).

### Process parameters:

Chamber temperature: 120-400°C in the example of embodiment - 200°C.

Introduction of trimethylaluminum: 100-150 ms in the example of embodiment - 125 ms.

Cleaning with nitrogen after trimethylaluminum: 500-1000 ms in the example of embodiment - 760 ms.

Introduction of water: 90-260 ms in the example of embodiment - 130 ms.

Cleaning with nitrogen after introducing water: 500-1500 ms in the example of embodiment - 760 ms.

### Surface characteristics (Fig. 10,11):

After aluminum(III) oxide layer deposition, the surface morphology is analyzed with the use of analytical techniques.

Morphology analysis: Quality and morphological features of the prepared Al₂O₃ nanostructures as well as Al₂O₃ nanostructures enriched with silver nanoparticles are examined with the use of atomic force microscopy.

The analysis of the atomic composition and size of nanograins: The percentage atomic composition of a layer is determined with the use of scanning electron microscopy with energy dispersive X-ray spectroscopy system (SEM/EDS). The average w/w ratio for the analyzed elements is: carbon: 2.00 - 10.00% (in the example of embodiment - 3.55%), oxygen 2.10-20.00%: (in the example of embodiment 13.77,%), aluminum: 3.50 - 27.00% (in the example of embodiment 14.60%), in another example of embodiment alternatively silver 0.1-2.5% in the example of embodiment 0.28%. The nanograins size 10-50nm, in the example 25±3nm.

XPS analysis: XPS analysis of the plate coated with Al₂O₃ layer enriched with silver nanoparticles. The measurement was carried out with the use of X-ray source (Al 1486.7eV anode). All the parameters of the apparatus are included in the exit file. Vacuum in the analysis chamber during the measurement was of the order 1x10 mbar. Data processing was carried out with the CasaXPS software, a baseline of the Shirley type was used to cut off the background, whereas signals were distributed into mixed Lorentz and Gauss lines. In the case of the metallic states, an asymmetric function was used for simulation. Atomic core region/atomic percentage (%) O 1s/18.59; C 1s/65.06, Ag 3d/13.30; Al 2p/3.05

UV-DRS analysis: Al₂O₃ I + Ag sample presents three different band gap values (Band Gap): 1.82 eV, 2.66 eV and 4.16 eV Each of these values corresponds to a specific wavelength at which the absorption maximum occurs (λ_max). For the energy of 1.82 eV, the absorption maximum occurs at the wavelength of 207.9 nm, for the energy of 2.66 eV - at 279.5 nm, whereas for the energy of 4.16 eV - at 419.5 nm. In turn, an Al₂O₃ sample shows slightly different properties. For this sample, three band gap values were identified: 2.50 eV, 4.42 eV and 5.96 eV. Corresponding maximum absorption wavelengths are: 200.5 nm for 2.50 eV, 264.5 nm for 4.42 eV and 431 nm for 5.96 eV, respectively. Considering the above data, it can be concluded that the addition of silver to an Al₂O₃ sample influences the change in the band gap value as well as shift of absorption maximum, which may evidence the modification of the electronic structure of the material and its optical properties.

As a result of the process described above, steel plates coated with aluminum(III) oxide nanolayers of precisely controlled thickness and morphology are obtained. These plates are ideally suited for use in NALDI technology, allowing efficient desorption and ionization of samples for their further spectrometric analysis.

### Example II.

In Example II, on a plate coated with Al₂O₃ layers in 1500 cycles prepared in Example I silver nanograins are deposited with the use of the CVD method, for applying in mass spectrometry, where desorption and ionization are assisted by these nanostructures (NALDI).

Silver nanograins deposition on Al₂O₃ layers with the use of the CVD method (on the reactor of our own production, of the *cold-wall* type)

The invention relates to an advanced method of chemical vapor deposition (CVD) applied for the enrichment of steel plates coated with an aluminum(III) oxide (Al₂O₃) layer with metallic silver nanograins for NALDI applications. The process is aimed at improving functional properties, in particular laser desorption/ionization processes and esthetic surfaces.

### Deposition procedure:

Substrate drying: Plates coated with aluminum(III) oxide (Al₂O₃) are dried in a stream of argon for 10 to 60min, in the example of embodiment - 30 min and placed on a CVD reactor stand.

Precursor: Silver(I) pentafluoropropionate trihydrate of the [Ag₅(O₂CC₂F₅)₅(H₂O)₃] molecular formula is applied as the source of silver nanograins. The appropriate amount of the precursor from 0.1µg to1000µg in the example of embodiment - 100µg, is weighed out and placed in a separate container on the CVD reactor stand. The silver nanograins size range is from 1nm to 100 nm (in the example of embodiment 20-35nm).

The conditions for deposition (CVD) process of the silver nanograins on steel plates coated with an Al₂O₃ layer: Evaporation temperature: 200-280°C (in the example of embodiment - 240°C). Decomposition and deposition temperature: 200-350°C (in the example of embodiment - 290°C). The carrier gas is argon (Ar). Total pressure in the reactor: 2.0 - 4.0 mbar (in the example of embodiment - 3.0 mbar). Sample heating time: 20-60 min (in the example of embodiment - 30 min). Deposition time: 30-120 min (in the example of embodiment - 60 minutes). Cooling and storage: After the deposition process has been completed, plates are left in an oven for cooling to the temperature of 10-35°C (in the example of embodiment - 23°C). After cooling, they are stored in a sealed and dry container, protected from light.

### Advantages and benefits of introducing silver nanograins on Al₂O₃ layers:

1. Strengthening the surface: Silver nanograins deposition on Al₂O₃ layers significantly increases the surface resistance to corrosion, external factors as well as activity of bacteria and microorganisms.
2. Esthetics: Metallic silver nanograins add esthetic appearance to the surfaces, making them more attractive for many applications.
3. Saving time and resources: The use of the CVD method enables silver deposition in a controlled manner, minimizing energy consumption in comparison with the traditional methods.

Steel plates coated with Al₂O₃ layers and enriched with silver nanograins can be used in various fields such as medicine (due to the antibacterial properties of silver), electronics, or cosmetic industry.

The invention constitutes a significant advance in the field of technology of materials, combining advanced methods of silver deposition on Al₂O₃ layers. Its potential can be implemented in a range of industrial sectors, bringing benefits both from the functionality as well as esthetics points of view.

### Application in mass spectrometry, in particular nanostructure assisted laser deposition/ ionization (NALDI) method:

1. Properties conducive to NALDI: the application of aluminum(III) oxide nanolayers as well as aluminum(III) oxide nanolayers coated with silver nanograins on steel plates improves the process of desorption/ionization of samples in the NALDI technique. It influences an increase in the detection sensitivity as well as improvement of the mass spectrum quality.
2. Sample application: Samples to analyze are deposited on previously prepared "spots" of the volume from 0.2µl to 5µl (in the example of embodiment - 0.5µl). As a result of an interaction with an aluminum(III) oxide nanolayer, they are left for cooling at room temperature. A sample is desorbed and ionized more efficiently.
3. Analysis in mass spectrometer: After a sample application, plates are introduced to a mass spectrometer.

An aluminum(III) oxide nanolayer and an aluminum(III) oxide nanolayer coated with silver nanograins acts as a catalyst for these processes, which results in obtaining mass spectra of better quality as well as detection of compounds of low concentration (m<3000 Da).

The application of NALDI Al₂O₃ targets and NALDI Al₂O₃ and silver targets in the NALDI-MS analysis

The application of plates coated with aluminum(III) oxide (Al₂O₃) nanolayers as well as aluminum(III) oxide (Al₂O₃) nanolayers enriched with silver nanograins as the substrates for a NALDI-MS analysis, which allows an improvement of the efficiency and quality of spectra analysis, especially of low molecular mass compounds.

Spectrometric measurements were carried out with the use of the UltrafleXtreme II MALDITOF-MS apparatus (Bruker Daltonics, Bremen, Germany) equipped with the UV laser (Nd:YAG).

### Technical parameters:

### Laser:

wavelength: 355 nm
Laser operation frequency: 1-2 kHz (in the example of embodiment 2 kHz)

### NALDI-MS spectra analysis:

Number of accumulated laser shots for one compound: 500-4000 shots (in the example of embodiment 2000; 4x500shots)

### NALDI-MS analysis parameters:

Positive and negative ionization mode
Range of analyzed compounds masses: 100 - 3000 Da (in the example of embodiment 60 - 1500 Da)
Global attenuator: 10-40% (in the example of embodiment - 30%)
Laser power: 10-100% (in the example of embodiment - 80% attenuator - 30%) Detector gain: 1,2-300x (in the example of embodiment 2.51x-30x)
Concentration of analyzed compounds: 1ng/mL - 30mg/mL

### IV. Advantages of applying plates coated with Al₂O₃ as well as plates coated with Al₂O₃ and silver nanograins:

Improvement of spectra quality (mass spectra): due to the application of plates coated with Al₂O₃ enriched with silver nanograins as the substrate, the obtained spectrum is more precise and clear, which enables better identification of compounds.

Increase in the analysis efficiency: Silver nanograins provide better absorption of laser energy, which allows more effective ionization of samples and better detection of low molecular mass compounds.

### Advantages and benefits:

1. Higher sensitivity: Due to aluminum(III) oxide nanolayers as well as aluminum(III) oxide nanolayers coated with silver nanograins, the detection sensitivity in the NALDI technique is significantly increased. It enables the detection of traces of low molecular mass compounds, which were previously difficult to identify with other LDI techniques such as MALDI.
2. Repeatability: Uniform and controlled layer deposition with the use of the ALD technique ensures high reproducibility of the process, which is crucial in scientific analyses.
3. Saving of material: The possibility to detect compounds at low concentrations results in using a smaller sample amount for an analysis.
4. Versatility: Plates coated with aluminum(III) oxide nanolayers as well as aluminum(III) oxide nanolayers with silver nanograins can be used for the analysis of a broad range of low molecular mass compounds < 3000 Da.

The invention is a breakthrough in the field of mass spectrometry offering a highly effective and precise tool for researchers. Aluminum(III) oxide nanolayers as well as aluminum(III) oxide nanolayers coated with silver nanograins on the steel plates contribute to a significant improvement of quality and sensitivity of analyses, which is of a huge importance in areas such as chemistry, biology or pharmaceutical science.

### Example III.

A method of preparing plates with aluminum(III) oxide nanolayers is characterized in that stainless steel plates are cleaned, degreased, and dried, and next compressed air is applied to the surface of the plates until spots of 0.10 mm in diameter and indentations of 0.1 mm in width are formed on the surface, next the plates are cleaned in an ultrasonic cleaner in a mixture of acetonitrile and ethanol in the volume ratio of 0.5:1 v/v of 99.95 % purity v/v, rinsed in distilled water, rinsed in acetone, dried in a stream of argon, and activated in a solution of trifluoroacetic acid at the concentration of 0.1%, and next, in the ALD deposition process, one layer of Al₂O₃ is deposited on the plate, of 10 nm in thickness, under the process conditions of 10 cycles, the chamber temperature of 120 °C, the introduction of a trimethylaluminum precursor 100 ms, cleaning with nitrogen after trimethylaluminum from 500 to 1000 ms, introduction of a water precursor 90 ms and cleaning with nitrogen after the introduction of water 500 ms. The steel is austenitic AISI 304 steel. As a result of the methodology, plates with aluminum(III) oxides were obtained.

### Example IV

A method of obtaining plates with aluminum(III) oxide nanolayers is characterized in that stainless steel plates are cleaned, degreased, and dried, and next compressed air is applied to the surface of the plates until spots of 10 mm in diameter and indentations of 0.5 mm in width are formed on the surface, next the plates are cleaned in an ultrasonic cleaner in a mixture of acetonitrile and ethanol in the volume ratio of 1:2 v/v of 99.959% purity v/v, rinsed in distilled water, rinsed in acetone, dried in a stream of argon, and activated in a solution of trifluoroacetic acid at the concentration of 10%, and next, in the ALD deposition process, ten layers of Al₂O₃ is deposited on the platesń, of 10 nm in thickness, under the process conditions of 500 cycles, the chamber temperature of 400°C, the introduction of a trimethylaluminum precursor 150 ms, and cleaning with nitrogen after trimethylaluminum 1000 ms, introduction of a water precursor 260 ms and cleaning with nitrogen after the introduction of water 1500 ms. The steel is ferritic AISI 430 steel. As a result of the methodology, plates with aluminum(III) oxides were prepared.

Example V differs from Example IV in that the applied steel is martensitic steel AISI 410 or duplex steel AISI 2205.

### Example VI.

A plate prepared according to Example IV with Al₂O₃ nanolayers is dried in a stream of argon for 10 minutes and silver nanograins are deposited in the CVD process with the use of silver(I) pentafluoropropionate trihydrate of the molecular formula [Ag₅(O₂CC₂F₅)₅(H₂O)₃] in the amount of 0.1µg, with the silver nanogains size of 1nm, at the evaporation temperature 200°C, decomposition and deposition temperature of 200°C, at the pressure in the reactor of 2,0 mbar, the time of heating the sample of 20 min and time of deposition of 30min, next after the deposition process the plates are cooled. The sizes of the plate are 2.5 × 7.5 cm. Cleaning is conducted by rinsing the plate surface with a solution of ethanol for 20 minutes, drying in a stream of argon for 1 minute, next rinsing with a solution of trichloroacetic acid at the concentration of 0.01% for 10 minutes. The plate is dried for 10 minutes in a stream of argon, rinsing in water and acetone is performed only once, for 2 min. Next, the plate is cooled to the temperature of 10°C in an oven, and after cooling it is stored in a sealed and dried container, with no access of light.

Example VII differs from Example VI in that the sizes of the plate are 1 × 5 cm or 10 x 30 cm. Cleaning is conducted by rinsing the plate surface with a solution of ethanol for 120 minutes, drying in a stream of argon for 1 minute, next rinsing with a solution of trichloroacetic acid at the concentration of 0.01% for 10 minutes. The plate is dried for 20 minutes in a stream of argon, rinsing in water and acetone is performed ten times, for 20 min. Next, the plate is cooled to the temperature of 35°C in an oven, and after cooling it is stored in a sealed and dried container, with no access of light.

## Claims

1. The method of obtaining plates coated with aluminum(III) oxide nanolayers **characterized in that** stainless steel plates are cleaned, degreased, and dried, and next compressed air is applied to the surface of the plates until spots of 0.10 to 10 mm in diameter and indentations of 0.1 mm to 0.5 mm in width are formed on the surface, next the plates are cleaned in an ultrasonic cleaner in a mixture of acetonitrile and ethanol in the volume ratio from 0.5:1 v/v to 1:2 v/v preferably 1:1 v/v of purity not lower than 99.95 % v/v, rinsed i distilled water, rinsed in acetone, dried in a stream of argon, and activated in a solution of trifluoroacetic acid at the concentration from 0.1% to 10%, and next, in the ALD deposition process, at least one layer of Al₂O₃ is deposited on the plate, preferably from one to twenty layers, of 1 to 10 nm in thickness, under the process conditions from 10 to 500 cycles, the chamber temperature from 120 to 400°C, the introduction of a trimethylaluminum precursor from 100 to 150 ms, cleaning with nitrogen after trimethylaluminum from 500 to 1000 ms, introduction of a water precursor from 90 to 260 ms and cleaning with nitrogen after the introduction of water from 500 to 1500 ms.

2. Method according to claim 1 **characterized in that** the plates with Al₂O₃ layers are dried in a stream of argon preferably in the time from 10 to 60 min and silver nanograins are deposited in the CVD process with the use of silver(I) pentafluoropropionate trihydrate of the molecular formula [Ag₅(O₂CC₂F₅)₅(H₂O)₃] in the amount from 0.1µg to 1000 µg, with the silver nanograins size from 1nm to 100 nm, at the evaporation temperature from 200°C to 280°C, decomposition and deposition temperature from 200°C to 350°C, at the pressure in the reactor from 2,0 to 4,0 mbar, the time of heating the sample from 20 to 60 min and time of deposition from 30 to 120 min, next after the deposition process the plates are cooled.

3. Method according to claim 1 or 2 **characterized in that** the sizes of the plate are from 0.5 to 30cm preferably 2.5 × 7.5 cm.

4. Method according to claim 1, 2, or 3 **characterized in that** the steel is austenitic preferably AISI 304, ferritic preferably AISI 430, martensitic preferably AISI 410, duplex steel preferably AISI 2205.

5. Method according to claim 1,2,3, or 4 **characterized in that** cleaning is conducted by rinsing the plate surface with a solution of ethanol preferably in the time from 20 to 120 minutes, drying preferably in a stream of argon or nitrogen most preferably in the time from 1 to 20, next rinsing with a solution of trichloroacetic acid of the concentration in the range from 0.01% to 10% most preferably in the time from 10 to 120 minutes.

6. Method according to claim 1,2,3,4 or 5 **characterized in that** the plate is dried for the time from 10 to 60 minutes.

7. Method according to claim 1,2,3,4,5 or 6 **characterized in that** rinsing in water and acetone is performed for one to ten times, preferably each time for 2 to 20 minutes.

8. Method according to claim 1,2,3,4,5,6, or 7 **characterized in that** the plates are a dried in a stream of argon.

9. Method according to claim 1,2,3,4,5,6,7, or 8 **characterized in that** the plates are cooled to the temperature of 10 to 35°C preferably in an oven.

10. Method according to claim 1,2,3,4,5,6,7,8, or 9 **characterized in that** after cooling the plates are stored in a sealed and dry container, preferably with no access to light.

11. The application of plates coated with aluminum(III) oxide nanolayers obtained according to claim from 1 to 10 for low molecular mass analysis with the use of the nanostructure assisted laser deposition/ionization NALDI technique.
